# EUROPEAN PATENT SPECIFICATION

(11) **EP 2 267 192 B1**
(45) Date of publication and mention of the grant of the patent: **31.07.2013**
(21) Application number: 08825824.9
(22) Date of filing: 27.10.2008
(51) Int. Cl.: C30B 29/06, C30B 15/10, C03B 19/09, C30B 35/00

(54) **METHOD OF PULLING SINGLE CRYSTAL SILICON USING A VITREOUS SILICA CRUCIBLE AND METHOD FOR MANUFACTURING QUARTZ GLASS CRUCIBLE**
VERFAHREN ZUR ZIEHUNG EINES SILIZIUMEINKRISTALLES UND VERFAHREN ZUR HERSTELLUNG EINES QUARZGLASTIEGELS
PROCEDE POUR LE TIRAGE D'UN MONOCRISTAL DE SILICIUM UTILISANT UN CREUSET DE VERRE DE SILICE ET PROCEDE DE FABRICATION DE CE CREUSET

(30) Priority: 25.10.2007 JP 2007277368
(43) Date of publication of application: 29.12.2010
(73) Proprietor: Japan Super Quartz Corporation, Akita city Akita 010-0065 (JP)
(72) Inventor: SATO, Masaru, Akita-shi Akita 010-0065 (JP)
(74) Representative: Gulde Hengelhaupt Ziebig & Schneider
(86) International application number: PCT/JP2008/069482
(87) International publication number: WO 2009/054529

(56) References cited:
- EP-A1- 1 020 546
- JP-A- 5 105 577
- JP-A- 6 279 167
- JP-A- 8 012 359
- JP-A- 11 278 855
- JP-A- 2002 284 596
- JP-A- 2004 250 304
- JP-A- 2005 289 710

## Description

### TECHNICAL FIELD

The present invention relates to a vitreous silica crucible used for pulling single-crystal silicon, and more particularly, to a vitreous silica crucible in which the vibration of a melt surface at the initial stage of the pulling of single-crystal silicon is suppressed, a shoulder portion of single-crystal silicon is stably formed and a high yield of single-crystal silicon is achieved, a method of manufacturing the same, and a use thereof.

### BACKGROUND ART OF THE INVENTION

A vitreous silica crucible in which a silicon melt is used for pulling single-crystal silicon. Since an inner surface portion (inner surface layer) of this vitreous silica crucible is in contact with the silicon melt, the inner surface portion of the vitreous silica crucible is formed of a transparent glass layer which does not substantially contains bubbles. Since an outer surface portion (outer surface layer) of the vitreous silica crucible disperses external radiant heat and uniformly transfers the heat to the inside of a mold, the outer surface portion of the vitreous silica crucible is formed of a bubble containing layer containing a plurality of bubbles.

As a method of manufacturing the vitreous silica crucible, conventionally, a rotary mold method is known. In this method, quartz powder deposited an an inner surface of a rotary mold is heated from a mold space and is vitrified to make a crucible. In this method, when heating and melting are performed, air within a quartz powder deposition layer is suctioned out from the mold side so as to perform depressurization and evacuation for eliminating the bubbles in a glass layer is performed. By this evacuation, the inner surface layer formed of the transparent glass layer which does not substantially contain bubbles is formed in the vitreous silica crucible (Patent Documents 1 and 2).

With respect to this vitreous silica crucible, there is known a single crystallization degree which is increased by controlling the amount of bubbles of a sidewall portion of the inner surface layer (transparent glass layer) to be 0.5 vol% or less, controlling the amount of bubbles of a curved portion to be 0.1 vol% or less, and controlling the amount of bubbles of a bottom to be 0.01 vol% or less (Patent Document 3). A quartz glass crucible in which vibration of the melt surface is suppressed by a bubble content in the inner peripheral surface of the upper portion of 0,01 to 0,2 % is described in Patent Document 4.
PATENT DOCUMENT 1: Japanese Unexamined Patent Application Publication No. 02-055285
PATENT DOCUMENT 2: Japanese Unexamined Patent Application Publication No. 10-017391]
PATENT DOCUMENT 3: Japanese Patent No. 2923720
PATENT DOCUMENT 4: Japanese Patent Application 2004-250304A

### DETAILED DESCRIPTION OF THE INVENTION

### PROBLEMS TO BE SOLVED BY THE INVENTION

Since pulling of single-crystal silicon (initial stage of pulling) is unstable until seed crystal which is brought into contact with the silicon melt is grown and thickened and then a shoulder portion of single-crystal silicon is formed, the pulling of the single-crystal silicon is readily influenced by the vibration of a melt surface and a pulled portion is susceptible to be cut. In the conventional vitreous silica crucible, since the amount of bubbles at a position corresponding to the melt surface of the silicon melt of the initial stage of the pulling is small, vibration of the melt surface and pulling failures are likely to occur.

In the conventional vitreous silica crucible, the amount of bubbles from the vicinity of the center of the inner surface layer to a lower side thereof is substantially uniform and is gradually increased toward a rim portion. However, since the amount of bubbles is increased near the center of the inner surface layer, the amount of bubbles near the center is large and thus the yield of single-crystal silicon deteriorates.

The present invention is designed to solve the problems of the conventional vitreous silica crucible. An object of the present invention is to provide a method of pulling-single-crystal silicon using a vitreous silica crucible capable of suppressing the vibration of a melt surface as set forth in claim 1 at the initial stage of the pulling of single-crystal silicon, stably forming a shoulder portion of single-crystal silicon and accomplishing high single crystallization degree of single-crystal silicon and a method of manufacturing the said crucible as set forth in claims 2.

### MEANS FOR SOLVING THE PROBLEM

The present invention relates to a vitreous silica crucible having the configuration shown in [1] to [6] as the means for solving the above-mentioned problems, a method of manufacturing the same, and the use thereof.
[1] A vitreous silica crucible for pulling single crystal, wherein an upper end portion of an inner surface layer of the crucible and a lower portion located below the upper end portion have a different amount of bubbles, the upper end portion ranges from a rim portion to a lowered melt surface at the initial stage of the pulling of the single-crystal silicon, the amount of bubbles in the lower portion is less than 0.1 vol% and the amount of bubbles in the upper end portion is 0.1 vol% or more, and, in the upper end portion, the amount of bubbles is increased toward the rim portion and the amount of bubbles in the upper end portion of the vitreous silica crucible increases by 0.002 vol% or more for every 1 mm the distance between the top of the crucible and the surface of the melt is increased.
[2] The vitreous silica crucible according to [1], wherein the lowered melt surface at the initial stage of the pulling of the single-crystal silicon is a melt surface position when a shoulder portion of the single-crystal silicon is formed.
[3] The vitreous silica crucible according to [1], wherein the amount of bubbles in the upper end portion of the vitreous silica crucible increases by 0.002 vol% to 0.008 vol% for every 1 mm the distance between the top of the crucible and the surface of the melt is increased..
[4] A method of manufacturing a vitreous silica crucible by a rotary mold method including performing evacuation, the method including: depositing vitreous silica powder for an outer surface layer on an inner surface of a mold and depositing synthetic fused silica powder for an inner surface layer on the vitreous silica powder for the outer surface layer; using synthetic fused silica powder, which is susceptible to formation of minute bubbles during heating and melting, as vitreous silica powder for forming an upper end portion of the inner surface layer; and heating, melting and vitrifying the vitreous silica powders by arc electrodes provided above a mole space.
[5] The method according to [4], wherein, as the synthetic fused silica powder, which is susceptible to formation of minute bubbles during heating and melting, the amorphous synthetic fused silica powder having an average particle diameter of 400 µm or less and a specific surface area of 0.06 m²/g or more, the amorphous synthetic fused silica powder having an average particle diameter of 100 µm or less, or the synthetic fused silica powder containing carbon in a range of from 5 ppm to 50 ppm is used.
[6] A method of pulling single-crystal silicon suppressing the vibration of a melt surface using the vitreous silica crucible according to any one of [1] to [3].
In addition, a method of pulling single-crystal silicon suppressing the vibration of a melt surface, using the vitreous silica crucible obtained by the method of manufacturing the vitreous silica crucible according to [4] or [5] above.

### ADVANTAGEOUS EFFECTS OF THE INVENTION

In the vitreous silica crucible of used in and made by the present invention, the upper end portion contains minute bubbles, the amount of bubbles of the upper end portion is 0.1 vol% or more, the amount of bubbles increases toward the rim portion, the amount of bubbles in the upper end portion of the vitreous silica crucible increases by 0.002 vol% or more for every 1 mm the level. Accordingly, the amount of bubbles in the upper end portion is large and thus the vibration of the melt surface is effectively suppressed at the initial stage of pulling the single-crystal silicon and the shoulder portion of the single-crystal silicon is stably formed. The upper end portion indicates a range of from the rim portion to the melt surface decline position of the initial stage of the pulling of the single-crystal silicon.

In the vitreous silica crucible, the increase ratio of the amount of bubbles of the upper end portion is in a range of from 0.002 vol% or more per height of 1 mm and more preferably in a range of from 0.002 vol% to 0.008 vol%, where vibration of the melt surface at the initial stage of pulling is suppressed. In contrast, the lower portion of the vitreous silica crucible located below than the melt surface position at the initial stage of pulling is a transparent glass layer of which the amount of bubbles is less than 0.1 vol%. Since the amount of bubbles is small, it is possible to stably pull the single-crystal silicon and obtain a high single crystallization degree of the single-crystal silicon.

The vitreous silica crucible is manufactured using a manufacturing method of a vitreous silica crucible by a rotary mold method including performing evacuation. In more detail, vitreous silica powder for an outer surface layer is deposited on an inner surface of a mold and synthetic fused silica powder for an inner surface layer is deposited on the vitreous silica powder for the outer surface layer, synthetic fused silica powder, which is susceptible to formation of minute bubbles at the time of heating and melting, is used as a vitreous silica powder for inner surface layer which forms an upper end portion of the inner surface layer, the vitreous silica powders are heated, melted and vitrified by arc electrodes provided above a mole space.
According to this manufacturing method, it is possible to obtain the vitreous silica crucible.

As the synthetic fused silica powder, which is susceptible to formation of minute bubbles at the time of heating and melting, (a) amorphous synthetic fused silica powder having an average particle diameter of 400 µm or less and a specific surface area of 0.06 m²/g or more, (b) amorphous synthetic fused silica powder having an average particle diameter of 100 µm or less, or (c) amorphous synthetic fused silica powder containing carbon in a range of from 5 ppm to 50 ppm is used. By using these synthetic fused silica powders, it is possible to form a glass layer containing minute bubbles having a diameter of from 40 µm to 200 µm.

By using the vitreous silica crucible, it is possible to effectively suppress the vibration of the melt surface at the time of pulling the single-crystal silicon.

### BRIEF DESCRIPTION OF THE DRAWINGS

FIG. 1 is a front cross-sectional view showing a vitreous silica crucible.
FIG. 2 is a front cross-sectional view showing pulling single-crystal silicon using the vitreous silica crucible.
FIG. 3 is a front cross-sectional view showing an apparatus for manufacturing a vitreous silica crucible.
FIG 4 is a graph showing the amount of minute bubbles of a vitreous silica crucible used in and made by the present invention.

### DESCRIPTION OF THE REFERENCE SYMBOLS

C: vitreous silica crucible
C1: inner surface layer
C3: upper end portion
C4: lower portion
C5: rim portion
10: rotary mold
11A: vitreous silica powder for outer surface layer
11B: vitreous silica powder for inner surface layer
11C: vitreous silica powder of upper end portion of inner surface layer
13: arc electrode

### BEST MODE FOR CARRYING OUT THE INVENTION

Hereinafter, the embodiments of the present Invention will be described with reference to the accompanying drawings.

### [Structure of Vitreous silica crucible]

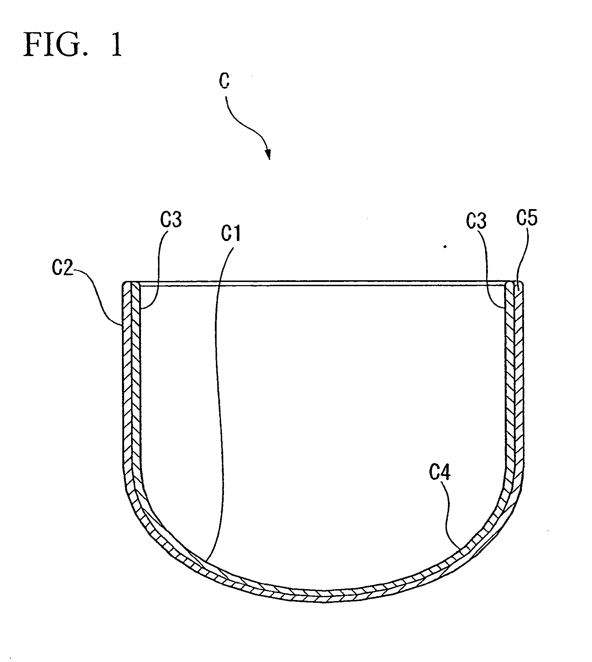

As shown in FIG 1, a vitreous silica crucible is a vitreous silica crucible C for pulling single crystal and includes an inner surface layer C1 which is brought into contact with a silicon melt at the time of pulling single crystal and an outer surface layer C2 of outer side. An upper end portion C3 of the inner surface layer C1 of the crucible and a lower portion C4 disposed below the upper end portion C3 are different from each other in the amount of bubbles they contain.

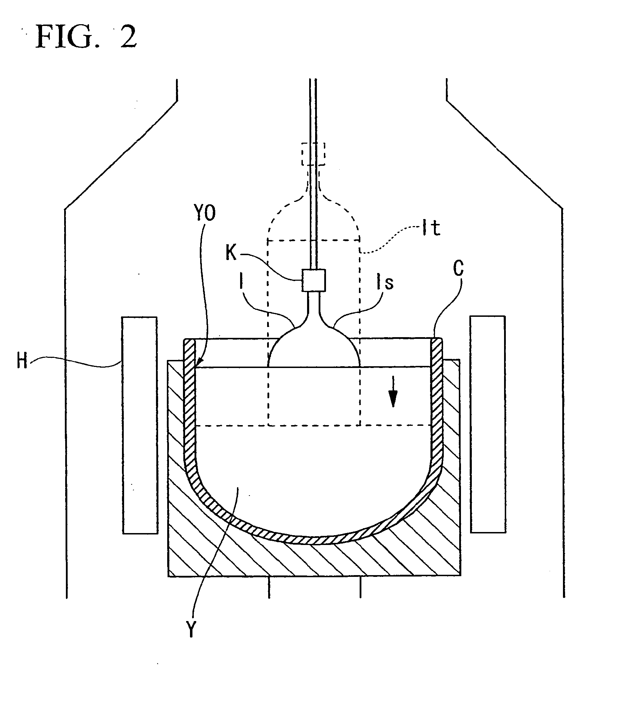

The upper end portion C3 of the inner surface layer C1 of the crucible corresponds to a range of from a rim portion C5 of the upper end to a decline position of the melt surface at the initial stage of the pulling of single-crystal silicon and more particularly, a range of from the rim portion C5 to a position of a melt surface which declines until a shoulder portion of single-crystal silicon is formed. The initial melt surface decline position indicates an initial melt surface decline position Y0 shown in FIG. 2. The initial lowered melt surface Y0 is the melt surface when a shoulder portion Is expands in order to form a straight barrel portion It, which can be sliced after the pulling is stopped and the necking removed, from the melt (silicon melt) Y heated in the crucible C by a heater H. The melt Y is brought into contact with seed crystal K so as to grow single crystal I in the pulling of single-crystal silicon using a CZ method. That is, the initial lowered melt surface indicates a melt height position where the formation of the straight barrel portion It is started. In the drawing, a state of the melt surface decline position and single-crystal silicon in which the formation of the shoulder Is is finished is denoted by a solid line and a state of the melt surface decline position and single-crystal silicon in which the straight barrel portion It is formed is denoted by a dotted line.

At the initial stage of the pulling of the single-crystal silicon, that is, until the seed crystal which is brought into contact with the silicon melt is grown and the shoulder portion Is of the single-crystal silicon is formed, the single-crystal silicon is unstable. Accordingly, the single-crystal silicon is readily influenced by the vibration of the melt surface. The vitreous silica crucible C suppresses vibration of the melt surface by increasing the amount of bubbles in the inner surface layer of the vitreous silica crucible C ranging from the initial surface of the melt to the lowered surface of the melt at the initial stage of the pulling.

In more detail, in the vitreous silica crucible C of the present invention, the upper end portion C3 of FIG. 1 includes minute bubbles, the amount of bubbles is 0.1 vol% or more and is increased toward the rim portion C5. The upper limit of the amount of bubbles of the upper end portion C3 is in a range of from 0.3 vol% to 1.0 vol%. If the amount of bubbles is 0.1 vol% or more, the single-crystal silicon is not greatly influenced by the vibration of the melt surface at the initial stage of pulling the single-crystal silicon.
The amount of bubbles in the upper end portion C3 of the vitreous silica crucible increases by 0.002 vol% or more for every 1 mm the distance between the top of the crucible and the surface of the melt is increased, and in a range of from 0.002 vol% to 0.008 vol% for every 1 mm the distance between the top of the crucible and the surface of the melt is increased.

The diameter of the minute bubbles is in a range of from 40 µm to 200 µm and preferably in a range of from 40 µm to 150 µm. In bubbles having a diameter of less than 40 µm, it is difficult to have a sufficient amount of bubbles. In the bubbles having a diameter of greater than 200 µm, the volume of the bubbles is large and thus has an influence on the amount of bubbles. However, since the number of bubbles per volume is reduced, a bubble containing volume is restricted and thus the influence of the vibration on the melt surface is reduced, which is not preferable.

The amount of bubbles in the upper end portion C3 increases toward the rim portion C5, the amount of bubbles in the upper end portion of the vitreous silica crucible increases by 0.002 vol% or more for every 1 mm the distance between the top of the crucible and the surface of the melt is increased, in a range of from 0.002 vol% to 0.008 vol% for every 1 mm the distance between the top of the crucible and the surface of the melt is increased, and preferably in a range of from 0.003 vol% to 0.007 vol%. If the increased amount of bubbles in the upper end portion C3 is less than 0.002 vol% for every 1 mm the distance between the top of the crucible and the surface of the melt is increased, the amount of bubbles in the upper end portion is insufficient. If the increased amount of bubbles is greater than 0.008 vol% for every 1 mm the distance between the top of the crucible and the surface of the melt is increased, a difference in bubble amount of the upper end portion C3 and the portion that changes from the upper end portion C3 into the lower portion C4 is excessively large. Accordingly, the transmissivity of the inner surface layer C1 is rapidly changed, the temperature distribution of the silicon melt Y shown in FIG. 2 is rapidly changed, and thus a collapse of the single crystal is likely to occur.

In the vitreous silica crucible C shown in FIG 2, the amount of bubbles in the lower side of the melt surface decline position Y0 at the initial stage of the pulling of the single-crystal silicon I, that is, the lower portion C4 shown in FIG. 1, is less than 0.1 vol%. Since the lower portion C4 is the transparent glass layer which does not substantially include bubbles, in the vitreous silica crucible C, heat transfer efficiency is excellent and heat transfer is uniform. Accordingly, the temperature change of the silicon melt Y (molten) does not occur and stable pulling can be continuously performed. Thus, it is possible to obtain a high degree of single crystallization.

As a detailed example, in the crucible C having a height of 500 mm of the crucible and having an opening diameter of 813 mm (32 inches), the amount of bubbles at a position of 500 mm (near center of the wall portion of the crucible (corresponding to the lower portion C4)) when measured from the center of the bottom of the crucible to the rim portion along the inner surface is less than 0.1 vol% and preferably 0 vol%. The amount of bubbles at a position of 750 mm (near center of the upper end portion C3 of the crucible) is 0.4 vol% or more and is preferably in a range of from 0.5 vol% to 1.0 vol%, for example, about 0.7 vol%.
In the crucible C, the total distance from the center of the bottom of the crucible to the rim portion along the inner surface is 800 mm.

In the pulling of the single-crystal silicon I, the shoulder portion Is of the single crystal is formed at the initial stage of the pulling and, when the liquid level of the silicon melt Y is slightly reduced by the pulling of the single-crystal silicon, the temperature of the liquid is slightly reduced in order to solidify the pulled single-crystal silicon. Since vibration in the melt surface is reduced, it is possible to stably perform the pulling even when the amount of minute bubbles of the upper end portion of the inner surface is gradually changed.

### [Configuration Material of Vitreous silica crucible]

In order to manufacture the vitreous silica crucible, vitreous silica powder for readily generating minute bubbles at the time of heating and melting is preferably used as raw powder (vitreous silica powder) of the upper end portion of the inner layer. In more detail, (a) an amorphous synthetic fused silica powder having an average particle diameter of 400 µm or less and having a specific surface area of 0.06 m²/g or more, (b) an amorphous synthetic fused silica powder having an average particle diameter of 100 µm or less, or (c) a synthetic fused silica powder containing carbon in a range of from 5 ppm to 50 ppm may be used. By using these vitreous silica powders, a glass layer containing minute bubbles having a diameter of 40 µm to 200 µm can be formed.
In addition, the average particle diameter indicates a volumetric average particle diameter. The average particle diameter is measured using a 20-g sample by a laser interference type particle size distribution measuring instrument.
The concentration of carbon is obtained by measuring carbon dioxide gas generated by the rising of the temperature of the sample using an infrared transmissivity measurement device.
As the raw powder (vitreous silica powder), synthetic fused silica powder may be used for the inner surface layer and natural quartz powder may be used for the outer surface layer.

The synthetic fused silica powder is composed of synthetic fused silica, the synthetic fused silica is a raw material which is chemically synthesized and manufactured, and synthetic fused silica powder is amorphous. The raw material of the synthetic fused silica is liquid or gas and can be readily purified. The synthetic fused silica powder has a purity higher than the natural quartz powder. The raw material of synthetic fused silica includes gas such as carbon tetrachloride and liquid such as silicon alkoxide. In the synthetic fused silica powder, the amount of all impurities is 0.1 ppm or less.

In the synthetic fused silica powder, silanol generated by hydrolysis of alkoxide by a sol-gel method remains in a range of 50 ppm to 100 ppm. In the synthetic fused silica composed of carbon tetrachloride, the residue of silanol can be controlled to be in a range of from 0 ppm to 1000 ppm, but chlorine is generally included to be about 100 ppm or more. If alkoxide is used as the raw material, a synthetic fused silica containing no chlorine can be readily obtained.
The synthetic fused silica powder using the sol-gel method contains silanol in a range of from 50 ppm to 100 ppm before melting as described above. If it is vacuum-melted, the silanol is eliminated or the silanol of the synthetic fused silica which can be obtained is reduced to be in a range of from 5 ppm to 30 ppm. The amount of silanol varies according to the melting conditions such as the melting temperature and room temperature. The amount of silanol of the synthetic fused silica which can be obtained by melting the natural quartz powder under the same condition is less than 5 ppm.

Generally, the synthetic fused silica has a viscosity lower than that of the vitreous silica which can be obtained by melting the natural quartz powder at a high temperature. This is because silanol or halogen cuts the mesh structure of the tetrahedron of SiO₄.
The glass obtained by melting the synthetic fused silica powder transmits ultraviolet rays well up to a wavelength of about 200 nm when measuring light transmissivity and thus has characteristics close to the synthetic fused silica using carbon tetrachloride used for the ultraviolet optical use as the raw material.
In the glass obtained by melting the synthetic fused silica powder, when measuring fluorescence spectrum which can be obtained by excitation of ultraviolet rays having a wavelength of 245 nm, the same fluorescence peak as the melt of the natural quartz powder cannot be observed.

In contrast, the natural quartz powder is composed of natural quartz. The natural quartz is a raw material which can be obtained by digging out, crushing and purifying of quartz stone existing in the natural world and the natural quartz powder contains crystal of α-quartz. The natural quartz powder contains Al and Ti by 1 ppm or more. In addition, the amount of metallic impurities in the natural quartz powder is higher than that of the synthetic fused silica powder. The natural quartz powder contains very little silanol. The amount of silanol of the glass which can be obtained by melting the natural quartz powder is less than 5 ppm.
In the glass obtained by melting the natural quartz powder, when measuring light transmissivity, since Ti is contained as impurities by about 1 ppm, light transmissivity is rapidly reduced if the wavelength becomes equal to or less than 250 nm and light transmissivity is greatly reduced at a wavelength of 200 nm. In addition, an absorption peak due to an oxygen defect can be observed when the wave length is around 245 nm.

In the melt of the natural quartz powder, when measuring the fluorescence spectrum which can be obtained by the excitation of the ultraviolet rays having a wavelength of 245 nm, fluorescence peaks are observed at 280 nm and 390 nm. These fluorescence peaks are generated due to oxygen coupling defects in the glass.
By measuring the concentration of the contained impurities, the difference in the amount of silanol, the light transmissivity, or the fluorescence spectrum which can be obtained by the excitation of the ultraviolet rays having the wavelength of 245 nm, it is possible to determine whether the glass material is the natural quartz or the synthetic fused silica.

Although, in the present invention, the vitreous silica powder is used as the raw powder, the "vitreous silica powder" described herein is not limited to quartz if the above-described condition is satisfied and may include powder composed of the known material such as crystal or silica sand including silicon dioxide (silica) as the raw material of the vitreous silica crucible.

### [Method of Manufacturing Vitreous silica crucible]

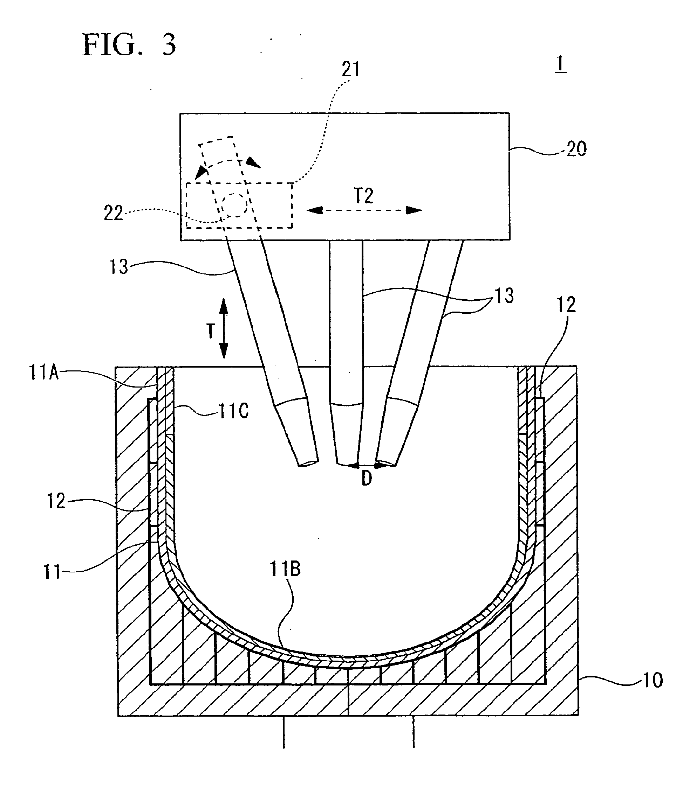

In a method of the present invention for manufacturing a vitreous silica crucible, as shown in FIG 3, an apparatus 1 for manufacturing the vitreous silica crucible including a rotary mold 10 for performing evacuation is used.
The apparatus 1 for manufacturing the vitreous silica crucible includes, as shown in FIG 3, the mold 10, a driving mechanism and carbon electrodes 13. The mold 10 has a melting space (mold space) for melting vitreous silica powder therein and forming the vitreous silica crucible. The driving mechanism rotates the mold 10 around the axial line thereof. A plurality of carbon electrodes 13 is provided as an arc discharge unit (arc electrode) for heating the inside of the mold 10.
The mold 10 is, for example, formed of carbon and a plurality of depressurization passages 12 for opening the inner surface of the mold 10 is formed therein. The depressurization passages 12 are connected to a depressurization mechanism. The mold 10 rotates and, at the same time, air is suctioned out from the inner surface thereof via the depressurization passages 12.
The plurality of carbon electrodes 13 is provided as the arc discharge unit above the mold 10 of the apparatus 1 for manufacturing the vitreous silica crucible. In the apparatus 1 for manufacturing the vitreous silica crucible of FIG 3, the electrodes 13 is formed by a combination of three polarities. These electrodes 13 are mounted in a support 20 which is located at the upper side of the furnace, and a unit (not shown) for vertically moving the electrodes 13 is provided in the support 20.
The support 20 includes support portions 21, a horizontal movement unit (not shown) and a vertical movement unit (not shown). The support portions 21 support the carbon electrodes 13 by setting the distance between the electrodes. The horizontal movement unit can move the support portions 21 in a horizontal direction T2. The vertical movement unit can integrally move the plurality of support portions 21 and the horizontal movement unit in a vertical direction T.
Each of the support portions 21 has an angle setting axis 22 which is a rotation unit. The carbon electrodes 13 are rotatably supported around the angle setting axis 22. In order to adjust the distance D between the carbon electrodes 13, the angles the carbon electrodes 13 are positioned at are controlled by the rotation unit, the horizontal positions of the support portions 21 are controlled by the horizontal movement unit, and the height positions of the support portions 21 are controlled by the vertical movement unit.
In addition, although the support 21 of the left carbon electrode 13 is shown, the other electrodes are supported by the same configuration and the heights of the carbon electrodes 13 can be individually controlled.

In the method of the present invention for manufacturing the vitreous silica crucible, vitreous silica powder 11A for the outer surface layer is fed into the inner surface of the rotary mold 10 so as to be deposited at a predetermined thickness. Vitreous silica powder 11B for the inner surface layer is fed onto the vitreous silica powder 11A for the outer surface layer so as to be deposited at a predetermined thickness. In this case, the vitreous silica powder 11B for the inner surface layer is deposited on the lower portion C4 which is lower than the position corresponding to the upper end portion C3 of the crucible C shown in FIG. 1. Thereafter, vitreous silica powder 11C which will form the upper portion of the inner surface layer of the crucible and is more susceptible to formation of minute bubbles therein than vitreous silica powder 11B at the time of heating is applied to a position corresponding to the upper portion C3. The feed order of the vitreous silica powder 11B and the vitreous silica powder 11C may be reversed.

The synthetic fused silica having low impurities is used for the vitreous silica powder 11B for the inner surface layer and the vitreous silica powder 11C for the upper end portion of the inner surface layer. The vitreous silica powder 11C which is used for the upper end portion of the inner surface layer includes (a) amorphous synthetic fused silica powder having an average particle diameter of 400 µm or less and having a specific surface area of 0.06 m²/g or more, (b) amorphous synthetic fused silica powder having an average particle diameter of 100 µm or less, or (c) synthetic fused silica powder containing carbon in a range of from 5 ppm to 50 ppm, as the vitreous silica powder will form the upper portion of glass layer of the crucible and is susceptible to formation of minute bubbles therein at the time of heating and melting. One or two or more types of the amorphous synthetic powder (a) to the amorphous synthetic fused silica powder (c) may be used.

The amorphous synthetic fused silica powder does not have a clear melting point at the time of heating and melting and the amorphous synthetic fused silica powder having an average particle diameter of 100 µm or less is likely to melt. Accordingly, the amorphous synthetic fused silica powder having an average particle diameter of 100 µm or less is vitrified while inserting gas between the particles of the vitreous silica powder and a glass layer having minute bubbles therein is formed. If the average particle diameter of the vitreous silica powder is less than 50 µm, the increase ratio of the amount of the bubbles of the upper end portion of the vitreous silica crucible is larger than 0.008 vol% for every 1 mm the distance between the top of the crucible and the surface of the melt is increased. Thus, the average particle diameter of the vitreous silica powder used for the upper end portion is preferably 50 µm or more and is more preferably in a range of from 60 µm to 100 µm.

Even when the average particle diameter is larger than 100 µm, the amorphous synthetic fused silica powder having an average particle diameter of 400 µm or less and having a specific surface area of 0.06 m²/g or more may form a glass layer containing minute bubbles. This is because the specific surface area is large, the amount of gas absorbed in the surface of the vitreous silica powder is large, and thus the vitreous silica powder is melted while inserting gas therein. The specific surface area is preferably 0.3 m²/g or less. This is because, if the specific surface area exceeds 0.3 m²/g, the content of volumetric bubbles exceeds a preferred range at the time of pulling. If the amorphous particles having an average particle diameter of greater than 400 µm are used, the particle diameter is large and thus it take a lot of time to perform vitrification. Accordingly, it is difficult to insert the gas.

The synthetic fused silica powder containing carbon in a range of from 5 ppm to 50 ppm and more preferably in a range of from 10 ppm to 45 ppm may be used. Since carbon is converted into gas at the time of heating and melting the synthetic fused silica powder and the synthetic fused silica powder is vitrified while inserting the gas, it is possible to form a glass layer containing minute bubbles. If the amount of carbon is less than 5 ppm, it is difficult to obtain a sufficient amount of bubbles and, if the amount of carbon is greater than 50 ppm, the amount of bubbles is excessive.

The amount of bubbles in the upper end portion C3 of the vitreous silica crucible increases by 0.002 vol% or more for every 1 mm the distance between the top of the crucible and the surface of the melt is increased, and in a range of from 0.002 vol% to 0.008 vol% for every 1 mm the distance between the top of the crucible and the surface of the melt is increased. In order to form the vitreous silica crucible having the amount of bubbles increases in the above-described range, for example, the closer the rim portion is, the smaller the average particle diameter of the vitreous silica powder is. In addition, if air is suctioned out from the surface of the mold at the time of heating and melting, the feed of air into the vitreous silica powder occurs near the surface of the rim portion of the vitreous silica powder molding 11. In this case, the amount of evacuation decreases towards the rim portion thereby increasing the bubble content. Accordingly, even when the vitreous silica powder having a uniform average particle diameter is to from the entire the upper end portion C3, it is possible to form the inner surface layer C1 having the amount of bubbles increases by adjusting the suction amount of air.

After the vitreous silica powder 11A, the vitreous silica powder 11B and the vitreous silica powder 11C are deposited, the vitreous silica powders are heated and melted to be vitrified using the arc electrodes 13 provided above the mold space, evaporation is performed at the time of melting so as to suctioned out the bubbles of the inner surface layer, and a transparent glass layer is formed. After vitrification, the transparent glass layer is cooled and is pulled out from the mold 10 so as to obtain the vitreous silica crucible C.

By using the vitreous silica crucible C, it is possible to effectively suppress the vibration of the melt surface at the time of pulling single-crystal silicon.

### EXAMPLES

The Examples of the present Invention will be described together with Comparative Examples.

### [Examples 1 to 3]

Using the manufacturing apparatus including the rotary mold shown in FIG. 3, the vitreous silica powder 11A for the outer surface layer was fed into the entire inner surface of the mold so as to be deposited at a predetermined thickness. The synthetic powder 11C having an average particle diameter of 100 4m or less shown in Table 1 was added to the vitreous silica powder for the outer surface layer of the upper end portion (corresponding to the upper end portion C3 shown in FIG. 1). Thereafter, the synthetic fused silica powder 11B having an average particle diameter in a range of from 150 4m to 300 gm was deposited an the lower portion (corresponding to the lower portion C4 shown in FIG 1) located below the upper end portion from the bottom. Subsequently, using the arc electrodes provided above the mold space, the vitreous silica powders were heated and melted vitrified, evaporation was performed at the time of melting, the bubbles of the inner surface layer were suctioned out, and the vitreous silica crucible (having an opening diameter of 81,28 cm (32 inches)) formed by the transparent glass layer as the inner surface layer was manufactured. Example 1 is not according to the present invention.

### [Example 4]

Using the manufacturing apparatus including the rotary mold shown in FIG. 3, the vitreous silica powder 11A for the outer surface layer was fed into the entire inner surface of the mold so as to be deposited at a predetermined thickness. The synthetic fused silica powder 11C having an average particle diameter of 250 µm and the specific surface area of 0.06 m²/g or more shown in Table 1 was add to the vitreous silica powder for the outer surface layer of the upper end portion (corresponding to the upper end portion C3 shown in FIG 1). Thereafter, the synthetic fused silica powder 11B having an average particle diameter in a range of from 150 µm to 300 µm was deposited an the 10 lower portion (corresponding to the lower portion C4 shown in FIG. 1) located below the upper end portion from the bottom. Subsequently, using the arc electrodes provided above the mold space, the vitreous silica powders were heated and melted vitrified, evaporation was performed at the time of melting, the bubbles of the inner surface layer were suctioned out, and the vitreous silica crucible (having an opening diameter of 81,28 cm (32 inches)) formed by the transparent glass layer as the inner surface layer was manufactured.

### [Comparative Examples 1 and 2]

As the vitreous silica powder for forming the inner surface layer, the synthetic fused silica powder in a range of from 150 p.m to 300 µm was used and, as the vitreous silica powder of the upper end portion, the vitreous silica powder having the above-described average particle diameter was used. In addition, the evaporation at the time of heating and melting was adjusted so as to adjust the amount of bubbles as shown in Table 1. In a state in which the other conditions are equal to those of Examples 1 to 3, a vitreous silica crucible (having an opening diameter of 81,28 cm (32 inches)) was manufactured.

### [Specific Surface Area]

The specific surface area (m²/g) of the synthetic fused silica powder for the upper end portion was measured using a BET method.

### [Increase Ratio of Bubbles]

The increase ratios of bubbles for every 1 mm the distance between the top of the crucible and the surface of the melt is increased (vol%/1) of the upper end portion of the vitreous silica crucibles obtained by the Examples and Comparative Examples were calculated as the increase ratio of the bubbles for every 1 mm the distance between the top of the crucible and the surface of the melt is increased, which is optically measured.

### [Amount of Bubbles]

The amounts (vol%) of bubbles near the center of the inner surface layer and the amounts (vol%) of bubbles in the upper end portion of the inner surface layer of the vitreous silica crucible of the Examples and the Comparative Examples were measured using Image processing after the bubbles are photographed by an optical unit.
The area near the center of the inner surface layer indicates a position of 400 mm from the center of the bottom along the inner surface in the vitreous silica crucible. The vitreous silica crucible hm a length of 800 mm from the center of the bottom to the rim portion along the inner surface, an opening diameter of 81,28 cm (32 inches) and a height of 500 mm. The area near the center of the inner surface corresponds to the lower portion C4 of the vitreous silica crucible C shown in FIG 1.
The upper end portion of the inner surface layer indicates a position of 750 mm from the center of the bottom of the vitreous silica crucible along the inner surface. 25 This corresponds to the upper end portion C3 of the vitreous silica crucible C shown in FIG. 1.

### [Pulling Evaluation]

Using the vitreous silica crucibles obtained by the Examples and the Comparative Examples, single-crystal silicon was pulled and the following evaluations were performed.

### (Vibration of Melt Surface)

None: the vibration of the melt surface is not visually observed
Small: the vibration of the melt surface is visually observed, but does not have an influence on an operation
Big: the vibration of the melt surface is visually observed and has an influence on an operation. This is unusable.

### (Remelt)

Non-existence: polycrystallization is not performed during the pulling of silicon
Existence: if polycrystallization is performed during the pulling of silicon, the grown crystal is melted and manufacture of single crystal is re-tried.

### (Si Yield)

The yield (single crystallization degree) (Si yield) of single-crystal silicon is the mass of a straight barrel portion which can form a wafer single-crystal silicon without crystal dislocation divide by the total mass of polysilicon fed into the crucible, when the single crystallization degree is changed by 1 mass%, the number of wafers collected is changed by 20.

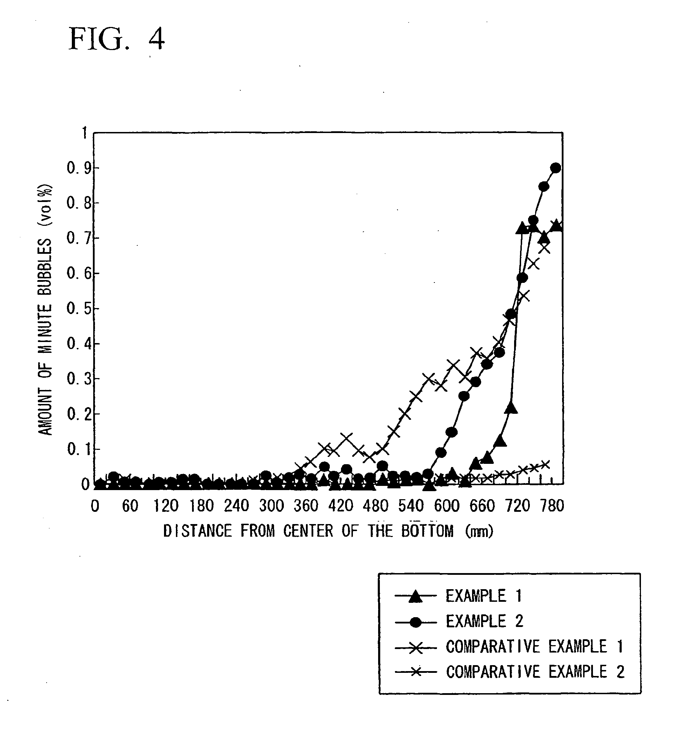

With respect to the vitreous silica crucibles of Examples 1 and 2 and Comparative Examples 1 and 2, the amount of bubbles is shown in FIG. 4. In addition, using the crucibles of Examples 1 to 4 and Comparative Examples 1 and 2, the single-crystal silicon was pulled. This result is shown in Table 1 together with the amount of bubbles in the upper end portion and the wall portion of the crucible and the increase ratio of bubbles.

As can be seen from FIG. 4 and the results of Table 1, in Example 1, the vibration of the melt surface is not generated when the necking formed at the initial stage of pulling, but the increase ratio of bubbles of the upper end portion is slightly large. Accordingly, alter the initial stage of the pulling of a single-crystal silicon, the variation in infrared ray transmissivity was large and the single crystal was cut immediately alter the melt surface of the silicon melt lowered from the upper end portion of the inner surface layer. Thus, remelt was performed. In contrast, in Examples 2 to 4, vibration of the melt surface and the remelt of the seed crystal at the initial stage of pulling are not generated. Even when the melt surface of the silicon melt declines from the upper end portion of the inner surface layer to the lower side, it is possible to perform stable pulling of the single-crystal silicon.

In contrast, in Comparative Example 1, since the amount in bubbles of the lower portion and the curved portion of the inner surface layer is large, the number of glass pieces which flip by the expansion of the bubbles is large, and thus the single-crystal silicon was frequently cut. In Comparative Example 2, since the amount of bubbles in the upper end portion (melt surface portion at the initial stage of pulling) of the inner surface layer is significantly reduced, vibration of the melt surface at the time of necking is frequently generated. Accordingly, the single-crystal silicon was cut many a time and remelted the seed crystal and thus the yield of the single-crystal silicon was low.

**Table. 1**

| | Synthetic Fused Silica Powder of Upper End Portion | | Vitreous Silica Crucible | | | Pulling Evaluation | | | Evaluation |
|---|---|---|---|---|---|---|---|---|---|
| | Average Particle Diameter (µm) | Specific Surface Area (m²/g) | Increase Ratio of Bubbles (vol%/mm) | Content of Bubbles near the Center of Inner Surface Layer (vol%) | Content of Bubbles in Upper End Portion of Inner Surface Layer (vol%) | Vibration of Melt Surface | Reattachment | Si Yield (mass%) | |
| Example 1 | 50 | 0.20 | 0.01 | 0 | 0.7 | None | Existence | 85 | ○ |
| Example 2 | 60 | 0.16 | 0.008 | 0 | 0.7 | None | Non-existence | 86 | ⊚ |
| Example 3 | 80 | 0.12 | 0.003 | 0 | 0.7 | None | Non-existence | 87 | ⊚ |
| Example 4 | 250 | 0.10 | 0.006 | 0 | 0.7 | None | Non-existence | 86 | ⊚ |
| Comparative Example 1 | Same as Lower Portion | 0.04 | 0.0016 | 0.1 | 0.7 | Small | Existence | 84 | Δ |
| Comparative Example 2 | | 0.04 | 0.0003 | 0 | 0.05 | Large | Existence | 80 | × |

| | | | | | | | | | |
|---|---|---|---|---|---|---|---|---|---|
| (Note) The average particle diameter and the specific surface area refer to the synthetic fused silica powder of the upper end portion of the inner surface layer. The vicinity of the center of the inner surface layer is a position of 400 mm from the center of the bottom along the inner surface. The upper end portion of the inner surface layer is a position of 750 mm from the center of the bottom along the inner surface. The increase ratio of bubbles show in the increase ratio of bubbles of the upper end portion of the inner surface layer. The Si yield is the yield of the single-crystal silicon ⊚ very good, ○: good, Δ: not so good, ×: bad | | | | | | | | | |

### INDUSTRIAL APPLICABILITY

The present invention relates to a vitreous silica crucible for pulling single-crystal silicon, a method of manufacturing the same, and the use thereof.
According to the vitreous silica crucible of the present invention, it is possible to suppress the vibration of a melt surface at the initial stage of the pulling of single-crystal silicon, to stably form a shoulder portion of single-crystal silicon, and to achieve a high yield of singlecrystal silicon.

## Claims

1. A method of pulling single-crystal silicon (I) suppressing the vibration of a melt surface using a vitreous silica crucible (C), wherein:
an upper end portion (C3) of an inner surface layer (C1) of the crucible (C) and a lower portion (C4) located below the upper end portion (C3) are different from each other in the amount of bubbles contained therein,
the upper end portion (C3) ranges from a rim portion (C5) to a lowered melt surface (YO) at the initial stage of the pulling of the single-crystal silicon (I), wherein the lowered melt surface (YO) is a melt surface position when a shoulder portion (Is) of the single-crystal silicon (I) is formed,
the amount of bubbles in the lower portion (C4) of the crucible (C) is less than 0.1 vol% and the amount of bubbles of the upper end portion (C3) is in a range of from 0.3 to 1.0 vol%, and
in the upper end portion (C3) of the crucible (C), the amount of bubbles increases toward the rim portion (C5) by 0.002 vol% to 0.008 vol% for every 1 mm distance from the surface of the melt (YO).

2. A method of manufacturing a vitreous silica crucible (C) using a rotary mold (10) method including performing evacuation, the method comprising:
depositing vitreous silica powder (11A) for an outer surface layer on an inner surface of a mold and depositing synthetic fused silica powder (11B) for an inner surface layer on the vitreous silica powder (11A) for the outer surface layer, wherein the vitreous silica powder (11B) for the inner surface layer is deposited on the lower portion (C4) which is lower than the position corresponding to the upper end portion (C3) of the crucible (C),
using synthetic fused silica powder (11C), which is susceptible to formation of minute bubbles having a diameter of from 40 µm to 200 µm during heating and melting, as vitreous silica powder for forming the upper end portion (C3) of the inner surface layer; and
heating, melting and vitrifying the vitreous silica powders by arc electrodes (13) provided above a mold space, wherein as the synthetic fused silica powder (11C), which is susceptible to formation of minute bubbles having a diameter of from 40 µm to 200 µm during heating and melting, a) amorphous synthetic fused silica powder having an average particle diameter of 400 µm or less and a specific surface area of 0.06 m²/g or more, or b) amorphous synthetic fused silica powder having an average particle diameter of 100 µm or less, is used.

## Patentansprüche

1. Verfahren zum Ziehen von monokristallinem Silicium (I), das die Vibration einer Schmelzoberfläche unterdrückt, unter Abwendung eines Quarzglasschmelztiegels (C), wobei:
sich ein oberes Endteil (C3) einer inneren Oberflächenschicht (C1) des Schmelztiegels (C) und ein unteres Teil (C4), das sich unter dem oberen Endteil (C3) befindet, von einander durch die Menge der darin enthaltenen Blasen unterscheiden,
das obere Endteil (C3) sich von einem Randteil (C5) bis zu einer gesenkten Schmelzoberfläche (YO) in der Anfangsstufe des Ziehens des monokristallinen Siliciums (I) erstreckt, wobei die gesenkte Schmelzoberfläche (YO) eine Schmelzoberflächenposition ist, wenn ein Schulterteil (Is) monokristallinen Siliciums (I) gebildet wird,
die Menge an Blasen in dem unteren Teil (C4) des Schmelztiegels (C) weniger als 0,1 Vol.-% beträgt und die Menge an Blasen des oberen Endteils (C3) im Bereich von 0,3 bis 1,0 Vol.-% liegt und
sich im oberen Endteil (C3) Schmelztiegels (C) die Menge an Blasen in Richtung Randteil (C5) jeden 1 mm Abstand von Oberfläche der Schmelze (YO) um 0,002 Vol.-% bis 0,008 Vol.-% erhöht

2. Verfahren zur Erstellung eines Quarzglasschmelztiegels (C) unter Anwendung eines Verfahrens mit rotierende Form (10) einschließlich der Durchführung der Entleerung, wobei das Verfahren umfasst:
Aufbringen von Quarzglaspulver (11A) für eine äußere Oberflächenschicht auf eine innere Oberfläche einer Form und Aufbringen von synthetischem Quarzglaspulver, (11B) für eine innere Oberflächenschicht auf dem Quarzglaspulver (11A) für die äußere Oberflächenschicht, wobei das Quarzglaspulver (11B) für die innere Oberflächenschicht auf den unteren Teil (C4) aufgebracht wird, der niedriger liegt als die Position, die dem oberen Endteil (C3) des Schmelztiegels (C) entspricht,
Verwenden von synthetischem Quarzglaspulver (11C), das während des Erhitzens und Schmelzens zur Bildung von winzigen Blasen befähigt ist, die einen Durchmesser von 40 µm bis 200 µm aufweisen, als Quarzglaspulver zum Bilden des oberen Endteils (C3) der inneren Oberflächenschicht; und
Erhitzen, Schmelzen und verglasten der Quarzglaspulver durch Lichtbogenelektroden (13), die über einem Formraum bereitgestellt sind, wobei als synthetisches Quarzglaspulver (11C), das zur Bildung von winzigen Blasen mit einem Durchmesser von 40 µm bis 200 µm während des Erhitzens und Schmelzens befähigt ist, a) amorphes synthetisches Quarzglaspulver, das eine durchschnittlichen Teilchendurchmesser von 400 µm oder weniger und einen spezifischen Oberflächenbereich von 0,06 m²/g oder mehr aufweist, oder b) amorphes synthtisches Quarzglaspulver, das einen durchschnittlichen Teilchendurchmesser von 100 µm oder weniger aufweist, verwendet wird.

## Revendications

1. Procédé d'étirage de silicium monocristallin (I) supprimant la vibration d'une surface de masse fondue en utilisant un creuset en silice vitreuse (C), dans lequel :
une partie d'extrémité supérieure (C3) d'une couche de surface intérieure (C1) du creuset (C) et une partie inférieure (C4) située en dessous de la partie d'extrémité supérieure (C3) sont différentes l'une de l'autre en terme de quantité de bulles qui y sont contenues,
la partie d'extrémité supérieure (C3) est comprise entre une partie de rebord (C5) et une surface de la masse fondue plus basse (YO) au stade initial de l'étirage du silicium monocristallin (I), la surface de la masse fondue plus basse (YO) étant une position de surface de la masse fondue lorsqu'une partie d'épaulement (Is) du silicium monocristallin (I) est formée,
la quantité de bulles dans la partie inférieure (C4) du creuset (C) est inférieure à 0,1 % en volume et la quantité de bulles de la partie d'extrémité supérieure (C3) est comprise dans la plage allant de 0,3 à 1,0 % en volume, et
dans la partie d'extrémité supérieure (C3) du creuset (C), la quantité de bulles augmente vers la partie de rebord (C5) de 0,002 % en volume à 0,008 % en volume tout les 1 mm de distance à partir de la surface de la masse fondue (YO).

2. Procédé de fabrication d'un creuset en silice vitreuse (C) utilisant un procédé de moulage rotatif (10) incluant une étape d'évacuation, le procédé comprenant :
le dépôt de poudre de silice vitreuse (11A) pour une couche de surface extérieure sur une surface intérieure d'un moule et le dépôt de poudre de silice fondue synthétique (11B) pour une couche de surface intérieure sur la poudre de silice vitreuse (11A) pour la couche de surface extérieure, la poudre de silice vitreuse (11B) pour la couche de surface intérieure étant déposée sur la partie inférieure (C4) qui a une position inférieure à la position correspondant à la partie d'extrémité supérieure (C3) du creuset (C),
l'utilisation d'une poudre de silice fondue synthétique (11C), qui est susceptibles de former de petites bulles ayant un diamètre de 40 µm à 200 µm lors du chauffage et de la fusion, sous forme de poudre de silice vitreuse pour former la partie d'extrémité supérieure (C3) de la couche de surface intérieure, et
le chauffage, la fusion et la vitrification des poudres de silice vitreuse par le biais d'électrodes d'arc (13) placées au-dessus d'un espace du moule, dans lequel comme poudre de silice fusionnée synthétique (11C), qui est susceptible de former de petites bulles ayant un diamètre de 40 µm à 200 µm pendant le chauffage et la fusion, on utilise a) une poudre de silice fondue synthétique amorphe ayant un diamètre moyen de particule inférieur ou égal à 400 µm et une surface spécifique supérieure ou égale à 0,06 m²/g, ou b) une poudre de silice fondue synthétique amorphe ayant un diamètre de particule moyen inférieur ou égal à 100 µm.
